# EUROPEAN PATENT SPECIFICATION

(11) **EP 1 178 135 B1**
(45) Date of publication and mention of the grant of the patent: **22.06.2011**
(21) Application number: 01304705.5
(22) Date of filing: 29.05.2001
(51) Int. Cl.: C30B 33/00, H03H 9/02

(54) **Piezoelectric oxide single crystal wafer**
Wafer aus piezoelektrischem einkristallinen Oxid
Plaquette d'oxyde monocristallin et piézoélectrique

(30) Priority: 30.05.2000 JP 2000159661
(43) Date of publication of application: 06.02.2002
(73) Proprietor: Shin-Etsu Chemical Co., Ltd., Chiyoda-ku, Tokyo (JP)
(72) Inventor: Murai, Toshinari, Annaka-shi, Gunma-ken (JP); Kuwabara, Yoshinori, Annaka-shi, Gunma-ken (JP)
(74) Representative: Cooper, John

(56) References cited:
- EP-A- 0 742 598
- PATENT ABSTRACTS OF JAPAN vol. 1995, no. 05, 30 June 1995 (1995-06-30) & JP 07 038360 A (MATSUSHITA ELECTRIC IND CO LTD), 7 February 1995 (1995-02-07)

## Description

### BACKGROUND OF THE INVENTION

### Field of the Invention

The present invention relates to a piezoelectric oxide single crystal wafer used for the production of surface acoustic wave filters and so forth, which consists of lithium tantalate.

### Related Art

In the field of mobile communications including PHS and cellular phones, piezoelectric oxide single crystal wafers consisting of lithium tanatalate, quartz crystal, lithium tetraborate, langasite or the like are utilized as substrates of surface acoustic wave elements. Conventionally, these piezoelectric oxide single crystal wafers are manufactured as follows. First, a single crystal ingot obtained by the Czochralski method or the like is sliced by using a slicer for inner diameter blade or a wire saw to produce a plate-like wafer. Subsequently, both surfaces of the obtained wafer are lapped to a predetermined thickness and one of the surfaces is mirror-polished by using a polishing apparatus. Then, the wafer can be cleaned with a predetermined chemical solution to obtain a piezoelectric oxide single crystal wafer.

In such a piezoelectric oxide single crystal wafer used for surface acoustic wave filters, the surface conditions after the cleaning and before electrode formation are particularly important. That is, in order to produce a surface acoustic wave filter from the aforementioned wafer, metal electrodes consisting of aluminium or the like must be formed on the piezoelectric oxide single crystal wafer, and if particles adhere to the wafer surface when a pattern is formed on the wafer surface by photolithography or the like, it becomes likely that metal electrodes are not formed at positions where the particles adhere. Therefore, piezoelectric oxide single crystal wafers desirably have as few particles as possible adhered to the wafer surfaces .

However, in piezoelectric oxide single crystal wafers manufactured by conventional methods as those for surface acoustic wave filters, many particles remain on wafer surfaces and therefore fine electrode formation may not be sufficiently attained in the element fabrication process. Thus, the number of good devices obtained from one wafer, i.e., yield, may be reduced.

In recent years, there is a trend that, especially as for surface acoustic wave filters, width of the aforementioned metal electrodes becomes smaller with use of higher radio-frequency, smaller size and lighter weight. For example, the width of metal electrodes must be 1 µm or less in devices of 1.9 GHz class. Therefore, if the electrode formation is performed under a condition that particles of at least 1 µm or more exist on the wafer surface, electrodes are not formed at positions of the particles and thus the device yield will be degraded.

While it is considered desirable that particles adhered to wafer surfaces should be made as few as possible for the reasons mentioned above, allowable size and number of such particles have not been elucidated yet.

EP-A-0742598 is concerned with manufacturing a piezoelectric composite substrate structure in which the substrate material is quartz, lithium niobate or lithium tanatalate, and includes cleaning the piezolelectric substrate with an aqueous solution of ammonia and hydrogen peroxide.

### SUMMARY OF THE INVENTION

Therefore, an object of the present invention is to provide a piezoelectric oxide single crystal wafer that allows fine electrode formation and thus enables device production with good yield.

In order to achieve the aforementioned object, the present invention provides a lithium tantalate single crystal wafer used for surface acoustic wave filters having an electrode width of 1 µm or less, wherein the number of particles adhering to a surface of the wafer and having a size of 1 µm or more is 85 or less per mm².

The invention further provides a method of preparing a lithium tantalate single crystal wafer for use in the production of surface acoustic wave filters having an electrode width of 1 µm or less, wherein cleaning conditions of the wafer are controlled such that number of particles adhering to a surface of the wafer and having a size of 1 µm or more after cleaning is 85 or less per mm².

The inventors of the present invention found that, in a piezoelectric oxide single crystal wafer after cleaning, there was a correlation between the number of particles adhering to the wafer surface and the yield obtained in the element fabrication utilizing the wafer. Then, they assiduously studied in order to achieve the aforementioned object, and as a result they found that, if a piezoelectric oxide single crystal wafer had particles adhering to a surface of the wafer and having a size of 1 µm or more in a number of 85 or less per mm², it satisfactorily allowed fine electrode formation in the element fabrication process and hence enabled device production with good yield. Thus, they accomplished the present invention. In particular, in the production of recent surface acoustic wave filters having a very small electrode width (1 µm or less), if a piezoelectric oxide single crystal wafer is used of which the number of particles adhering to a surface and having a size of 1 µm or more is 85 or less per mm², surface acoustic wave filters can be produced with a high yield of at least 50% or more.

Since the piezoelectric oxide single crystal wafer of the present invention has a few particles adhering to a surface of the wafer and having a size of 1 µm or more, i.e., 85 or less per mm², it advantageously enables formation of recently used fine electrodes and thus enables production of surface acoustic wave filters with an extremely high yield.

### BRIEF EXPLANATION OF THE DRAWING

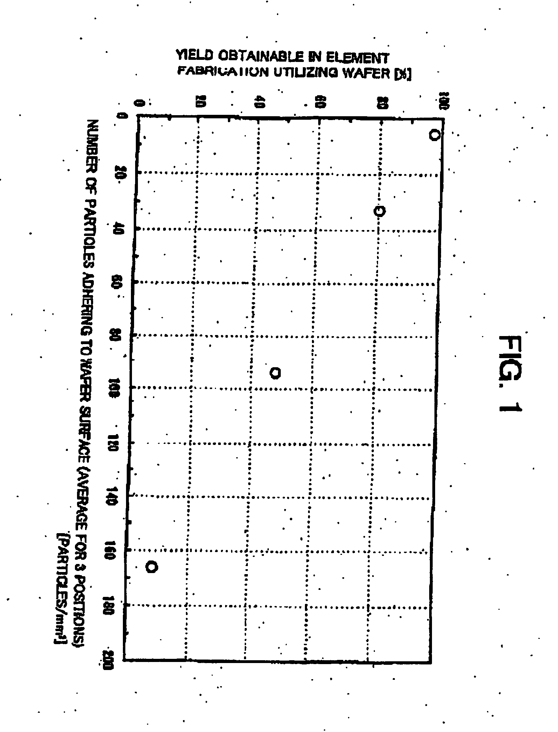

Fig. 1 represents a graph showing the relationship between the number of particles adhered to a wafer surface and the yield obtainable in element fabrication utilizing the wafer.

### PREFERRED EMBODIMENTS OF THE INVENTION

Hereafter, embodiments of the present invention will be explained specifically. However, the present invention is not limited to these.

The present invention provides a piezoelectric oxide single crystal wafer of which the number of particles adhering to a surface and having a size of 1 µm or more is 85 or less per mm². Material of the piezoelectric oxide single crystal wafer is lithium tantalate

A method for producing such a piezoelectric oxide single crystal wafer will be explained as for a lithium tantalate single crystal. Usually, a single crystal ingot of lithium tantalate is grown by the single crystal pulling method (CZ method) or the like, and sliced into a plate-like wafer. This wafer is ground to a desired thickness by lapping both the surfaces, and subjected to a mirror-polishing process generally called polishing. Since the wafer surface has adhered dust particles, i.e., polishing agent and ground powder, after the polishing a desired lithium tantalate single crystal wafer can be obtained after the wafer is cleaned with a predetermined chemical solution in order to remove the dust particles.

In the present invention, the number of particles adhering to a surface of the wafer and having a size of 1 µm or more can be made 85 or less, preferably 15 or less, per mm² by appropriately controlling cleaning conditions after a single crystal ingot is grown by the aforementioned method and sliced, and the obtained wafer is made into a mirror polished wafer by subjecting the wafer to lapping, polishing and so forth.

As the cleaning method of the wafer, various procedures and flows may be contemplated. It was revealed that the number of particles adhered to a finished wafer might increase or decrease depending on the cleaning method. In the present invention, tests may be performed beforehand to determine such cleaning conditions including cleanliness of cleaning solution, cleaning time and frequency for ultrasonic cleaning that the number of particles adhering to a surface of the wafer and having a size of 1 µm or more should become less than 85 or less per mm².

The number of particles adhering to a surface of the wafer and having a size of 1 µm or more can be determined by various evaluation methods, for example, by measurement through a dark field microscopy, measurement through a laser microscopy, measurement utilizing optical interference, measurement utilizing a wafer particle counter and so forth. When there is a problem in light transmission in measurement utilizing optical means, a film that does not transmit light, for example, a thin metal film, can be formed by vapor deposition and the measurement can be performed for its surface to determine the number of particles per unit area.

The piezoelectric oxide single crystal wafer of the present invention, in which the number of particles having a size of 1 µm or more on the surface is suppressed to be less than the predetermined number, can be then made into desired surface acoustic wave devices by forming electrodes of aluminium etc. in a conventional manner. In particular, it can be suitably used for acoustic wave filters. In order to produce a surface acoustic wave filter, for example, a film mainly consisting of aluminium is coated on the mirror-polished electrode forming surface of the piezoelectric single crystal wafer in a conventional manner. Then, surface acoustic wave filters can be produced with an extremely high yield by forming electrodes in a desired shape such as comb-shaped electrodes by a fine processing technique utilizing photolithography or the like and cutting the wafer into chips.

Use of higher radio-frequency, smaller size and lighter weight has become popular, in particular, as for surface acoustic wave filters, and the metal electrode width becomes 1 µm or less in devices of 1.9 GHz class. Therefore, particles having a size of 1 µm or more must be removed as far as possible. Replying to such a situation, surface acoustic wave filters can be produced with a high yield of at least 50% or more by using piezoelectric oxide single crystal wafers with 85/mm² or less of particles having a size of 1 µm or more and adhering to a surface of the wafer, or they can preferably be produced with an extremely high yield of 95% or more by using piezoelectric oxide single crystal wafers with 15/mm² or less of such particles. That is, if the piezoelectric oxide single crystal wafer of the present invention is used, metal electrodes can be advantageously formed even in the recent fine fabrication process and thus highly precise devices can be produced with an extremely high yield.

### EXAMPLES

Hereafter, the present invention will be explained more specifically with reference to the following examples and comparative examples. However, the present invention is not limited to these.

### (Example 1)

As piezoelectric oxide single crystal wafers for surface acoustic wave filters, a plurality of lithium tantalate wafers having a diameter of 7.5 cm (3 inches) were prepared and subjected to ultrasonic cleaning at a specific frequency using a predetermined chemical solution. The chemical solution used in this experiment was a fresh solution. A metal film was provided by the sputtering method on a surface of each wafer after the cleaning, and the number of bright spots was counted at three predetermined positions using a dark field microscope at 200 magnification (microscopic field area: 0.594 mm²). As a result, the number was found to be in the range of 2-8 per field (3-14 per mm²).

### (Example 2)

A plurality of lithium tantalate wafers similar to those of Example 1 were prepared and subjected to ultrasonic cleaning at a specific frequency using a predetermined chemical solution. The chemical solution used in this experiment was a relatively fresh solution at about 1/3 of exchange criterion. A metal film was provided by the sputtering method on a surface of each wafer after the cleaning, and number of bright spots was counted at three predetermined positions using the same dark field microscope as used in Example 1. As a result, the number was found to be in the range of 17-23 per field (28-39 per mm²).

### (Comparative Example 1)

A plurality of lithium tantalate wafers similar to those of Example 1 were prepared and subjected to ultrasonic cleaning at a specific frequency using a predetermined chemical solution. The chemical solution used in this experiment was a relatively old solution at about 2/3 of exchange criterion. A metal film was provided by the sputtering method on a surface of each wafer after the cleaning, and number of bright spots was counted at three predetermined positions using the same dark field microscope as used in Example 1. As a result, the number was found to be in the range of 53-64 per field (89-108 per mm²).

### (Comparative Example 2)

A plurality of lithium tantalate wafers similar to those of Example 1 were prepared and subjected to ultrasonic cleaning at a specific frequency using a predetermined chemical solution. The chemical solution used in this experiment was an old solution immediately before exchange. A metal film was provided by the sputtering method on a surface of each wafer after the cleaning, and number of bright spots was counted at three predetermined positions using the same dark field microscope as used in Example 1. As a result, the number was found to be in the range of 92-111 per field (155-187 per mm²).

An average of the bright spot numbers counted at 3 positions was used as the number of particles adhering to the surface for each of the lithium tantalate wafers obtained in the examples and comparative examples. These wafers were cut into a usual size for element fabrication to produce chips, and it was determined if these chips had desired device functions to calculate good chip ratio (yield) among the chips obtained from one wafer.

Based on the results of the above series of evaluations, the relationship between the number of particles adhered to the wafer surface and the yield obtainable in element fabrication utilizing the wafer is obtained and shown in Fig. 1.

As seen from the results shown in Fig. 1, all of the lithium tantalate wafers obtained in the examples showed a good chip yield of about 80% or more. In particular, chips could be produced from the wafers of Example 1 (particle number: 3-14 per mm²) with an extremely high good chip yield of 95% or more. On the other hand, the good chip yield was less than 50% for all of the lithium tantalate wafers obtained in the comparative examples. In particular, the yield did not reach even 15% for the lithium tantalate wafer of Comparative Example 2 (particle number: 155-187 per mm²).

Thus, it can be seen that the lithium tantalate wafers of the present invention obtained in the examples had fewer particles adhering to the wafer surfaces compared with those obtained in the comparative examples, and they enabled device production with an extremely high yield by fine electrode formation in the element fabrication process.

The present invention is not limited to the embodiments described above. The above-described embodiments are mere examples, and those having the substantially same structure as that described in the appended claims and providing the similar functions and advantages are included in the scope of the present invention as defined in the accompanying claims.

For example, while the examples were explained for use of lithium tantalate wafers having a diameter of 7.5 cm (3 inches), the advantages of the present invention can be similarly obtained regardless of the wafer diameter.

## Claims

1. A lithium tantalate single crystal wafer used for surface acoustic wave filters having an electrode width of 1 µm or less, **characterized in that** number of particles adhering to a surface of the wafer and having a size of 1 µm or more is 85 or less per mm².

## Patentansprüche

1. Ein Lithium-Tantalat-Einkristallwafer, der für akustische Oberflächenwellenfilter mit einer Elektrodenbreite von 1 µm oder weniger verwendet wird, **dadurch gekennzeichnet, dass** die Anzahl an Partikeln, die an einer Oberfläche des Wafers haften und eine Größe von 1 µm oder mehr aufweisen, 85 oder weniger pro mm² beträgt.

## Revendications

1. Une plaquette de monocristal de tantalate de lithium utilisée pour des filtres à ondes acoustiques de surface ayant une largeur d'électrode de 1 µm ou moins, **caractérisée en ce que** le nombre de particules adhérant à une surface de la plaquette et ayant une taille de 1 µm ou plus est de 85 ou moins par mm².
